Europäisches Patentamt

European Patent Office

Office européen des brevets

(19)

(11) **EP 1 283 425 A1**

(12) **DEMANDE DE BREVET EUROPEEN**

(43) Date de publication:
   **12.02.2003 Bulletin 2003/07**

(51) Int Cl.7: **G01R 31/36**

(21) Numéro de dépôt: **02291831.2**

(22) Date de dépôt: **18.07.2002**

(84) Etats contractants désignés:
   **AT BE BG CH CY CZ DE DK EE ES FI FR GB GR
   IE IT LI LU MC NL PT SE SK TR**
   Etats d'extension désignés:
   **AL LT LV MK RO SI**

(30) Priorité: **10.08.2001 FR 0110704**

(71) Demandeur: **Peugeot Citroen Automobiles SA
   92200 Neuilly sur Seine (FR)**

(72) Inventeur: **Vacher, Cécile
   92600 Asniere (FR)**

(74) Mandataire: **Grynwald, Albert
   Cabinet Grynwald,
   127, rue du Faubourg Poissonnière
   75009 Paris (FR)**

(54) **Procédé d'estimation de paramètres de la batterie de puissance d'un véhicule a moteur électrique**

(57) L'invention concerne un procédé pour la détermination d'au moins un paramètre de fonctionnement de la batterie (12) de puissance d'un véhicule comportant un moteur de traction électrique.

Le paramètre de la batterie étant constitué par au moins un des paramètres suivants : la puissance de charge, la puissance de décharge, l'état de surcharge et l'état de décharge profonde, on détermine la résistance interne de la batterie de puissance et l'intensité du courant fourni ou reçu pour estimer le ou les paramètres.

Cette résistance interne est par exemple estimée à l'aide d'une batterie auxiliaire basse tension (18).

FIG_1

## Description

La présente invention est relative à un procédé et à un dispositif d'estimation de paramètres d'un générateur de courant continu rechargeable, ou batterie d'accumulateurs, pour l'alimentation d'un moteur électrique pour véhicule automobile.

Elle concerne plus particulièrement, mais non exclusivement, un procédé et un dispositif d'estimation de caractéristiques d'une batterie de puissance d'un véhicule de type hybride.

On rappelle ici qu'un véhicule automobile de type hybride comporte, pour la traction, d'une part, un moteur thermique à combustion interne, et, d'autre part, un moteur électrique alimenté par une batterie de puissance. Le moteur thermique sert non seulement à entraîner le véhicule mais également à faire tourner un alternateur qui charge la batterie de puissance par l'intermédiaire d'un redresseur de courant. La décision d'effectuer la commande de la traction du véhicule, soit par le moteur thermique, soit par le moteur électrique, soit par les deux à la fois, est prise en général de façon automatique en fonction, notamment, de l'état de charge de la batterie et de la puissance de décharge de cette batterie. Le déclenchement et l'arrêt de la charge de la batterie sont également effectués de façon automatique grâce à des moyens de détection de décharge profonde et de détection de surcharge.

Pour déterminer l'état de charge d'une batterie de puissance, il est connu de cumuler l'énergie fournie et l'énergie reçue (en ampères-heures). Ce cumul peut également être utilisé pour déterminer l'état de vieillissement de la batterie de puissance.

L'état de charge de la batterie s'exprime en % d'une charge maximale. Pour les états de charge compris entre 30 et 80 % environ, la tension délivrée par la batterie présente une valeur déterminée. Par contre, pour les états de charge inférieurs à 30 % environ, la tension délivrée diminue avec l'état de charge et, de façon analogue, pour les états de charge supérieurs à 80 % environ, la tension augmente avec l'état de charge.

La détection de la surcharge consiste à comparer à un premier seuil la tension délivrée par la batterie à courant nul et à déclencher un arrêt de la charge et/ou une alerte de surcharge quand la tension dépasse ce premier seuil.

De même, la détection de la décharge profonde de la batterie s'effectue par comparaison de la tension de cette dernière à courant nul avec un second seuil, le déclenchement de la charge et/ou d'une alerte de décharge s'effectuant quand la tension de la batterie descend en dessous de ce second seuil.

L'invention résulte de la constatation que la méthode connue de l'estimation de la puissance de charge et de décharge, et les méthodes de détection des états de surcharge et de décharge profonde, sont d'une précision insuffisante pour une gestion correcte de la batterie et de la marche du véhicule. Par exemple, une estimation imprécise de la puissance de décharge de la batterie ne permet pas de déterminer avec certitude si le moteur électrique pourra, en complément du moteur thermique, fournir un couple suffisant pour assurer les prestations dynamiques attendues par le conducteur. Par exemple encore, une imprécision sur la surcharge ou l'état de décharge profonde peut entraîner des déclenchements intempestifs d'alertes.

Pour remédier à ces inconvénients, l'invention prévoit de déterminer la résistance interne de la batterie et de tenir compte de cette résistance interne pour la détermination de l'un au moins des paramètres suivants : l'estimation de la puissance de charge, l'estimation de la puissance de décharge, la détection de la surcharge et la détection de la décharge profonde.

Ainsi, la puissance de charge et de décharge de la batterie peut être déterminée par la formule suivante :

$$P = UI = U\frac{E \pm U}{R} \qquad (1)$$

Dans cette formule U est la tension aux bornes de la batterie, E est sa force électromotrice (en décharge), ou contre-électromotrice (en charge), R la résistance interne de la batterie et I l'intensité mesurée du courant fourni (en décharge) ou reçu (en charge). De plus, dans cette formule, le signe + correspond à la charge et le signe - à la décharge.

La tension U peut être mesurée directement. Par contre, l'estimation du paramètre E est effectuée à partir d'un tableau de correspondance, mis en mémoire en usine, entre la valeur E et l'état de charge (en %) estimé par le cumul de l'énergie reçue ou fournie et, éventuellement, de la température de la batterie. La résistance R de la batterie est mesurée et, de préférence, corrigée, comme expliqué ci-après.

Le tableau de correspondance à une ou deux entrées est, par exemple, déterminé de façon empirique à l'aide de mesures sur un nombre important de batteries de même nature et mêmes caractéristiques que celle implantée dans le véhicule.

Pour déterminer le seuil $U_{max}$ pour la détection de la surcharge, on peut faire appel à la relation suivante :

$$U_{max} = E_{90\%} + R_{90\%}\,I. \qquad (2)$$

Dans cette formule $E_{90\%}$ et $R_{90\%}$ sont, respectivement, la force contre-électromotrice de la batterie et sa résistance interne pour un état de charge de l'ordre de 90 %. Bien entendu, la valeur de 90 % qui est utilisée pour l'état de charge constitue un exemple d'un état de charge pour lequel la force contre-électromotrice est supérieure à la force contre-électromotrice pour un état de charge nominal (en général, compris entre 30 et 80 % comme indiqué ci-dessus).

Les termes $U_{max}$, I et, en général, $R_{90\%}$ peuvent être mesurés. Par contre, la force contre-électromotrice $E_{90\%}$ est extraite d'une mémoire comme expliqué ci-dessus. Le terme $R_{90\%}$ peut aussi être extrait d'une table comme expliqué plus loin.

De façon analogue, on détermine le second seuil pour la détection de la décharge profonde à l'aide de la formule suivante :

$$U_{min} = E_{30\%} - R_{30\%}\ I. \qquad (3)$$

Dans cette formule $E_{30\%}$ est la force électromotrice de la batterie pour un état de charge de l'ordre de 30 %, c'est-à-dire pour un état de charge se trouvant en dessous de l'état de charge nominal, et $R_{30\%}$ est la résistance interne de la batterie pour le même état de charge.

La valeur $E_{30\%}$ est déterminée à l'aide d'une mémoire contenant un tableau de correspondance entre l'état de charge et la force électromotrice. Ce tableau de correspondance qui, de préférence, fait aussi intervenir la température comme grandeur d'entrée, est mis en mémoire en usine et résulte de déterminations empiriques comme dans le cas de la force contre-électromotrice.

Il est à noter que la mesure de la résistance interne peut également être utilisée pour diagnostiquer le vieillissement de la batterie par comparaison avec une valeur nominale. En effet, on sait que la résistance interne de la batterie augmente de façon importante sur le dernier tiers de sa vie.

L'invention s'applique notamment aux batteries de type $N_iMH$ et $N_iCD$.

Selon un autre aspect de l'invention, qui peut s'utiliser indépendamment des autres aspects expliqués ci-dessus, pour mesurer la résistance interne de la batterie de puissance, on fait appel à une batterie auxiliaire, en général de plus basse tension que la batterie de puissance, qui est appelée quelquefois batterie "de servitude", et on charge la batterie de puissance par l'intermédiaire de cette batterie "de servitude" en faisant délivrer à cette batterie de servitude deux courants électriques d'intensités, respectivement $I_2$ et $I_1$, et on mesure les tensions $U_2$ et $U_1$ aux bornes de la batterie de puissance avec ces deux courants. Ainsi, la résistance interne a la valeur suivante :

$$R = \frac{U_2 - U_1}{I_2 - I_1} \qquad (4)$$

De cette manière, la mesure de la résistance ne fait pas intervenir la force contre-électromotrice ou électromotrice de la batterie.

Pour permettre la charge de la batterie de puissance par la batterie de servitude, et, de même, pour permettre la charge de la batterie de servitude par la batterie de puissance, il est nécessaire de prévoir un convertisseur continu-continu de type réversible entre ces deux batteries. Par convertisseur "réversible" on entend un convertisseur qui permet de transformer la haute tension de la batterie de puissance en une basse tension égale à celle de la batterie de servitude et, réciproquement, qui transforme la basse tension de la batterie de servitude en une haute tension égale à celle de la batterie de puissance.

En variante, on mesure la résistance interne de la batterie de puissance en faisant appel au courant fourni par l'alternateur et le redresseur associés. Mais pour une mesure précise, il est, dans ce cas, nécessaire de faire appel à un stabilisateur de tension ou de courant (du fait des variations inévitables de la tension fournie par l'alternateur), ce qui, en raison d'un coût supérieur, est moins avantageux que la première réalisation.

Selon encore un autre aspect de l'invention, qui peut s'utiliser aussi indépendamment des autres aspects définis ci-dessus, pour tenir compte du fait que la résistance interne de la batterie de puissance ne peut pas être mesurée en permanence alors que les détections de l'état de charge, de la surcharge et de la décharge profonde doivent être effectuées à des fréquences plus élevées, on affecte à la résistance interne mesurée une correction qui dépend de l'état de charge et, de préférence, de la température. Ainsi, la résistance interne de la batterie chargée est plus faible que la résistance interne déchargée.

En charge, la résistance interne a la valeur suivante :

$$R = R_0 + R_c \qquad (5)$$

Dans cette formule, le terme correctif est $R_C$. Il est fonction de l'état de charge et, de préférence, de la température. Ainsi, on prévoit une mémoire, chargée en usine, pour fournir les termes correctifs en fonction de l'état de charge et, de préférence, de la température.

De même, dans le cas de la décharge, la résistance interne R' peut s'exprimer par la formule suivante :

$$R' = R_0' + R_d \qquad (6)$$

Dans cette formule, $R_d$ est le terme correctif prévu en cas de décharge. Ce terme correctif dépend aussi de l'état de charge et, de préférence, de la température. On prévoit donc une mémoire chargée en usine qui fournit ce terme correctif.

Il va de soi que les termes additifs de correction $R_c$ et $R_d$ peuvent être remplacés par des termes multiplicatifs $\lambda_0$ et $\lambda_d$, c'est-à-dire : $R = \lambda_c R_o$ et $R' = \lambda_d R_o$.

Il faut tenir compte du terme correctif $R_c$ ou $R_d$ (ou $\lambda_c$ et $\lambda_d$)quand on mesure la résistance interne. Ainsi, quand on a obtenu, par mesure, la résistance R, il faut en déduire $R_0$ ou $R'_0$ en y retranchant le terme correctif qui est fonction de l'état de charge et, éventuellement, de la température. Soit, dans le cas de la charge :

$$R_0 = R - R_c \qquad (7)$$

et, dans le cas de la décharge :

$$R'_0 = R' - R_d \qquad (8)$$

La valeur de la résistance interne R qui est utilisée lors des diverses évaluations est déduite des formules (5) et (6), c'est-à-dire qu'à la valeur, $R_0$ ou $R'_0$, ainsi déterminée on rajoute le terme correctif $R_C$ ou $R_d$ qui dépend de l'état de charge et, de préférence, de la température.

On peut prévoir une correction de la valeur de la résistance interne qui dépend du paramètre à estimer. Dans ce cas on fournit, pour chaque estimation à effectuer, (surcharge, décharge profonde, puissance de charge, puissance de décharge) un tableau de correspondance spécifique entre la valeur de correction de la résistance interne et l'état de charge et, de préférence, de la température.

En outre, pour tenir compte de l'effet de la polarisation de la batterie, on peut faire dépendre le terme correctif du temps au bout duquel le paramètre concerné doit être estimé.

Par exemple, dans le cas d'une estimation de la puissance disponible en charge le terme correctif à apporter à la résistance interne dépend du but de cette estimation, c'est-à-dire, notamment, du temps au bout duquel il est nécessaire de connaître la puissance de charge. Ainsi, à titre d'illustration, une charge effectuée par l'intermédiaire d'un alternateur entraîné par un moteur thermique nécessite une estimation de la charge à effectuer sur un temps relativement important, tandis qu'une estimation de la puissance de charge disponible dans le cas d'un freinage au cours duquel on récupère l'énergie dissipée pour charger la batterie, nécessite une connaissance de la puissance de charge sur quelques secondes.

Par exemple, encore pour l'estimation de la charge, on prévoira un tableau de correspondance entre la température et la correction à apporter à la valeur de la résistance interne en fonction de la surcharge que l'on souhaite détecter. Dans l'exemple ci-dessus, il s'agit d'une correction pour un état de charge de 90 %.

De façon analogue, en décharge, on prévoit des tableaux de correspondance pour le terme correctif à apporter à la résistance interne qui, pour l'estimation de la puissance disponible en décharge, dépend de l'état de charge, de préférence de la température, et du temps au bout duquel le paramètre doit être estimé. Ainsi, quand la batterie de puissance alimente le moteur électrique de traction pour que le véhicule effectue un dépassement, il faut connaître la puissance disponible en décharge sur une durée de quelques secondes, par exemple six secondes, et la résistance interne n'a pas la même valeur pour cette durée que pour une durée de trois secondes ou pour une durée plus longue.

De même, pour la détection de la décharge profonde, on prévoit un tableau de correspondance qui fournit, en fonction de la température, le terme correctif à apporter à la résistance interne pour l'état de charge (30% par exemple) correspondant au seuil fixé pour déclencher l'alerte ou provoquer prioritairement la charge.

La valeur de la résistance interne constitue un paramètre permettant de déterminer l'état de vieillissement d'une batterie car sur le dernier tiers de sa durée de vie, cette résistance augmente de façon sensible. Dans ce cas, la correction à apporter à cette valeur permet d'améliorer l'estimation de l'état de vieillissement.

Le terme correctif peut être adapté à la nature du diagnostic de vieillissement. En effet, le diagnostic de vieillissement effectué automatiquement dans le véhicule consiste à comparer la résistance interne à un seuil, alors que le diagnostic de vieillissement, qui peut être effectué dans un service après-vente, consiste à comparer la courbe de variation de la résistance interne à une courbe type obtenue de façon empirique.

Dans le cas où la résistance interne est mesurée à l'aide de la batterie de servitude, il est préférable, pour la précision de la mesure, que, dans le cas d'un véhicule hybride, le moteur thermique soit à l'arrêt et que, de même, le moteur de traction électrique ne soit pas alimenté. Ainsi, dans ce cas, les mesures s'effectuent hors contact. À cet effet, on peut profiter du mode d'"auto-réveil", généralement prévu dans de tels véhicules à batterie de puissance, pour déterminer l'autodécharge de la batterie. Ce mode d'auto-réveil est mis en marche automatiquement après l'arrêt du véhicule, par exemple une heure après la mise en contact, et de façon périodique, par exemple toutes les heures.

Ainsi, dans une réalisation, lors de l'auto-réveil, outre le calcul de l'autodécharge, on effectue les opérations suivantes : l'estimation de la résistance interne de la batterie et l'égalisation de la charge des éléments d'une batterie lorsque ceux-ci sont à un état de charge élevé mais distincts les uns des autres.

Dans une variante, l'estimation de la résistance interne est effectuée selon une fréquence plus faible que l'auto-réveil, par exemple une fois par an ou après un nombre déterminé d'ampères-heures échangés ou encore uniquement par un service après-vente.

Dans le cas d'un service après-vente, on prévoit une entrée de déclenchement de l'estimation de la résistance interne et une sortie sur laquelle on recueille le résultat de l'estimation.

L'invention concerne ainsi, de façon générale, un procédé pour la détermination d'au moins un paramètre de fonctionnement de la batterie de puissance d'un véhicule comportant un moteur de traction électrique. Ce procédé est tel que :

- le paramètre de la batterie est constitué par au moins un des paramètres suivants : la puissance de charge, la puissance de décharge, l'état de surcharge et l'état de décharge profonde, et
- on détermine la résistance interne de la batterie de puissance et l'intensité du courant fourni ou reçu pour estimer le ou les paramètres.

Si le paramètre est l'état de puissance de charge et/ou de décharge de la batterie, l'estimation de la puissance de charge et/ou décharge peut faire appel à l'équation suivante :

$$P = U\frac{E \pm U}{R} \qquad (1),$$

formule dans laquelle U est la tension aux bornes de la batterie de puissance, E est la force électromotrice ou contre-électromotrice et R sa résistance interne, le signe + correspondant à la charge de la batterie et le signe - à la décharge de la batterie.

Si le paramètre est l'état de surcharge, on peut déterminer le seuil $U_{max}$ de tension aux bornes de la batterie à partir de la formule suivante :

$$U_{max} = E_{N\%} + R_{N\%}\ I,$$

formule dans laquelle $E_{N\%}$ est la force contre-électromotrice de la batterie pour un état de charge déterminé supérieur à un état de charge nominal, $R_{N\%}$ est la résistance interne de la batterie pour ce même état de charge, et I est l'intensité du courant absorbé par la batterie.

Si le paramètre est l'état de décharge profonde, on peut déterminer le seuil $U_{min}$ de tension aux bornes de la batterie en dessous duquel il est estimé que la batterie est en décharge profonde à l'aide de la formule suivante :

$$U_{min} = E_{n\%} - R_{n\%}\ I,$$

formule dans laquelle $E_{n\%}$ est la force électromotrice pour un état de charge inférieur à une valeur nominale, $R_{n\%}$ est la valeur de la résistance interne de la batterie pour le même état de charge inférieur à la valeur nominale, et I est l'intensité du courant fourni par la batterie.

Dans une réalisation, la force électromotrice ou contre-électromotrice de la batterie est prédéterminée en fonction de l'état de charge (SOC).

La force électromotrice ou contre-électromotrice peut également être prédéterminée en fonction de la température de la batterie.

Selon un mode de réalisation, on affecte à chaque valeur mesurée de résistance interne de la batterie un terme correctif qui dépend de l'état de polarisation de la batterie.

On peut faire dépendre ce terme correctif de la température.

Le terme correctif peut dépendre du paramètre à estimer et, éventuellement, du temps au bout duquel le paramètre doit être estimé.

La détermination de la résistance interne peut être utilisée en vue de détecter l'état de vieillissement de la batterie.

Dans une réalisation, la résistance interne de la batterie est déterminée à l'aide d'une batterie auxiliaire basse tension reliée à la batterie de puissance par l'intermédiaire d'un convertisseur continu-continu de type réversible. Cette estimation de la résistance interne est effectuée de préférence lorsque la batterie est hors contact.

L'estimation de la résistance interne peut être effectuée de façon périodique de façon automatique, par exemple simultanément à des périodes d'estimation d'autodécharge de la batterie de puissance.

Selon un mode de réalisation, la détermination d'au moins un paramètre de fonctionnement de la batterie de puissance du véhicule comportant la détermination de la résistance interne de la batterie de puissance et de l'intensité du courant fourni ou reçu pour estimer le ou les paramètre(s), est déclenchée à l'aide d'un signal externe au véhicule et le résultat de l'estimation est recueilli à l'extérieur du véhicule.

L'invention concerne aussi l'application du procédé à l'estimation de paramètres d'une batterie de puissance d'un véhicule de type hybride comprenant, outre le moteur de traction électrique, un moteur de traction de type thermique qui est également utilisé pour charger la batterie par l'intermédiaire d'un alternateur.

D'autres caractéristiques et avantages de l'invention apparaîtront avec la description de certains de ses modes de réalisation, celle-ci étant effectuée en se référant aux dessins ci-annexés sur lesquels :

La figure 1 est un schéma montrant certains éléments d'un véhicule hybride selon l'invention,
les figure 2 et 3 sont des diagrammes montrant les propriétés d'une batterie de puissance, et
les figures 4a à 4c sont des schémas montrant certains éléments de commande d'un dispositif conforme à l'invention.

L'exemple que l'on va décrire avec les figures concerne un véhicule du type hybride comportant deux moteurs de traction, à savoir un moteur thermique 10 et un moteur électrique (non montré) alimenté par une batterie de puissance 12.

Le moteur thermique 10 entraîne un alternateur 14 qui charge la batterie de puissance 12 par l'intermédiaire d'un redresseur 16.

Le véhicule comporte aussi une batterie basse tension 18 destinée à l'alimentation des divers circuits de commande et de régulation du véhicule. Entre la batterie de puissance 12 et la batterie de servitude 18, on prévoit un convertisseur continu-continu réversible 20. Ce convertisseur 20 permet de charger la batterie 18 par la batterie 12 et à cet effet il abaisse la tension. Ce convertisseur 20, dans l'autre sens, augmente la tension fournie par la batterie 18 pour alimenter la batterie 12.

Lorsque la batterie 18 fournit un courant à la batterie haute tension 12, ce courant est stable alors que le courant fourni par le redresseur 16 est beaucoup moins stable en raison des variations de régime du moteur thermique 10.

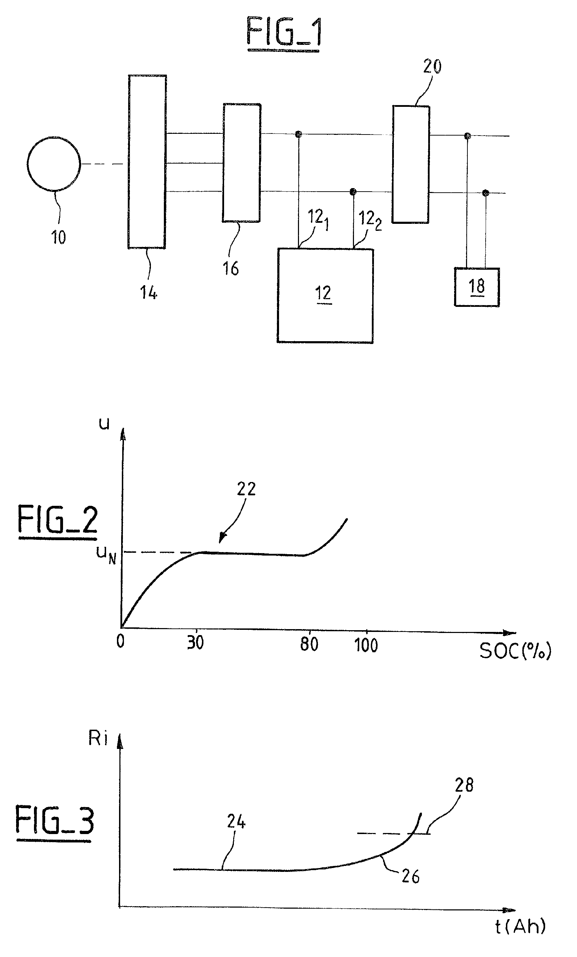

Les diagrammes des figures 2 et 3 représentent un certain nombre de propriétés de la batterie de puissance 12.

Sur le diagramme de la figure 2, on a porté en abscisses l'état de charge (SOC) exprimé en pour cent, de la batterie 12, et en ordonnées la tension 4 aux bornes $12_1$, $12_2$ de la batterie. On voit que, pour un état de charge compris entre 30 et 80% la tension U fournie par la batterie présente, pour un courant débité d'intensité nulle, une valeur sensiblement constante, $U_N$, alors que cette tension diminue avec l'état de charge lorsque ce dernier est inférieur à 30 %, et augmente avec cet état de charge lorsque celui-ci est supérieur à 80 %.

Etant donné que la courbe 22 représentée sur le diagramme de la figure 2 correspond à un courant d'intensité nulle (ou, de façon générale, à un courant constant), elle ne représente pas correctement les propriétés de la batterie 12 lorsque celle-ci est en charge ou en décharge, c'est-à-dire lorsqu'elle est en cours d'utilisation. Pour permettre une meilleure connaissance des diverses caractéristiques de la batterie, on prévoit de mesurer la résistance interne de cette dernière, de préférence par l'intermédiaire de la batterie basse tension et donc du convertisseur réversible 20.

Cette connaissance de la résistance interne de la batterie permet une estimation précise de la puissance de charge et de décharge de cette batterie et contribue ainsi à l'optimisation de l'énergie du véhicule. En effet, la gestion de l'énergie électrique de la batterie est un problème difficile à résoudre car elle doit satisfaire à des exigences contradictoires, à savoir une maximisation de l'autonomie (et donc une minimisation de la consommation) et une maximisation des performances (entraînant une consommation élevée). Pour l'estimation précise de la puissance de charge et de décharge de la batterie, il faut également connaître l'état de charge. La connaissance de l'état de charge permet aussi de déterminer le seuil de tension au-dessus duquel la batterie est en surcharge et le seuil de tension en dessous duquel la batterie est en décharge profonde. Comme indiqué ci-dessus, pour cette connaissance précise des seuils, il faut une estimation précise de la résistance interne de la batterie.

L'état de charge (SOC) de la batterie 12 est déterminé par cumul des ampères-heures reçus et fournis par cette batterie.

Enfin, la connaissance de la résistance interne permet de déterminer l'état de vieillissement de la batterie de puissance car, comme montré sur le diagramme de la figure 3, sur lequel on a porté en abscisses le nombre d'ampères-heures échangés par la batterie et en ordonnées la résistance interne $R_i$, la résistance interne présente au cours des deux premiers tiers 24 de son utilisation une valeur pratiquement constante et cette résistance augmente de façon sensible (partie 26) au cours du dernier tiers de sa durée de vie. Ainsi, on peut déclencher une alerte quand la résistance interne dépasse un seuil déterminé 28.

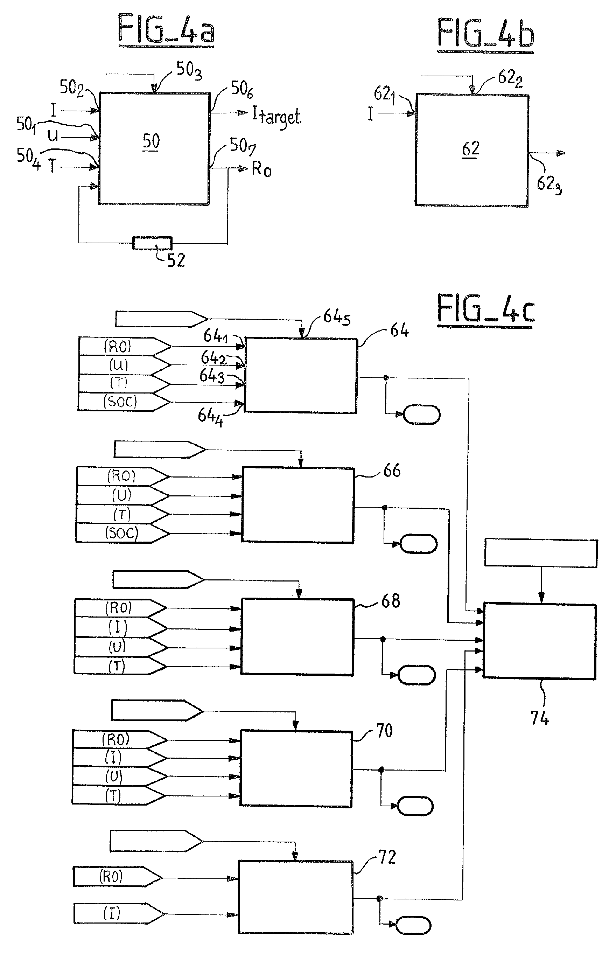

On se réfère maintenant aux figures 4a, 4b et 4c qui sont des schémas montrant des dispositifs utilisés pour effectuer les diverses estimations conformes à l'invention.

La figure 4a est un schéma montrant le dispositif de détermination de la résistance interne de la batterie 12 dans lequel on prévoit des moyens de calcul et de mémoire 50 qui permettent, d'une part, de calculer la résistance interne selon la formule (5) expliquée ci-dessus, grâce à des entrées $50_1$ et $50_2$ recevant des signaux représentant, respectivement, la valeur U de la tension et l'intensité I du courant. On obtient ainsi en sortie la valeur $R_0$ ou $R'_0$ telle qu'indiquée par les formules (7) et (8) ci-dessus.

Etant donné que, dans l'exemple, on apporte des termes correctifs à ajouter à la valeur $R_0$ ou $R'_0$ qui dépendent de l'état de charge SOC et de la température T, on prévoit donc une entrée $50_3$ sur laquelle on applique un signal 52 représentant les conditions d'estimation de la valeur $R_0$, c'est-à-dire l'état de charge SOC et le but de l'estimation, c'est-à-dire : la détection de puissance de charge maximale, la détection de puissance de décharge maximale, la détection de surcharge, la détection de décharge profonde ou l'estimation du vieillissement. En outre, pour les conditions de charge et de décharge, on tient compte également du but de la détermination, c'est-à-dire du temps au bout duquel on souhaite connaître l'état de charge ou de décharge.

La température détectée est appliquée sur une entrée $50_4$ des moyens 50. Ces moyens 50 comprennent ainsi une ou plusieurs mémoires contenant des tableaux de correspondance fournissant les valeurs de correction à apporter à la résistance interne en fonction de l'état de charge, de la température et du temps au bout duquel on souhaite connaître la résistance interne.

Le moyen 50 comporte aussi une sortie $50_6$ fournissant une valeur $I_{target}$ qui est la consigne de courant, servant de base aux calculs d'estimation. Si l'intensité I mesurée, appliquée sur l'entrée $50_2$ est différente de la consigne, soit on corrige cette consigne soit on interrompt l'estimation.

Enfin, on prévoit un élément de retard 52 entre la sortie $50_7$, fournissant la valeur $R_0$, et une entrée de comparaison. L'élément de retard permet de comparer la valeur de $R_0$ précédemment mesurée à la nouvelle valeur calculée. Le calcul est accepté si la nouvelle valeur est supérieure à la précédente. En effet, la résistance interne d'une batterie augmente constamment et si on constate une diminution, le calculateur considère que l'estimation est erronée. On notera ici que la résistance interne n'est pas mesurée en permanence mais de façon périodique, par exemple tous les trois ou six mois ou tous les ans.

Le schéma de la figure 4b représente un dispositif permettant de déterminer l'état de charge SOC.

Ce dispositif comporte un bloc 62 d'estimation ampèremétrique de l'état de charge SOC comprenant une entrée $62_1$ recevant un signal représentant l'intensité du courant et une entrée $62_2$ recevant un signal représentant la phase de conduite. Ce bloc 62 a pour but de comptabiliser les ampères-heures de charge et de décharge. Ainsi, le signal apparaissant sur la sortie $62_3$ du bloc 62 est un signal représentant l'état de charge.

La figure 4c est un schéma montrant les divers moyens qui exploitent les signaux $R_0$ et SOC fournis par les blocs, respectivement 50 et 62, pour la gestion du système de commande du véhicule et notamment des signaux d'alerte. (ou de façon générale à courant constant)

On prévoit ainsi un premier bloc 64 qui fournit un signal d'estimation de puissance de charge maximale en fonction de signaux sur ses entrées $64_1$ à $64_5$. Ces signaux représentent respectivement, $R_0$, U, T, SOC et la phase de conduite.

Un bloc 66 fournit une estimation de la puissance maximale de décharge. Ses entrées reçoivent également des signaux représentant $R_0$, U, T, SOC et l'état de conduite.

Un bloc 68 est destiné à fournir un signal d'alerte de surcharge en fonction des données $R_0$, I, U, T et de l'état de conduite.

De même, un bloc 70 fournit un signal d'état de décharge profonde en fonction des signaux représentant $R_0$, I, U, T et l'état de conduite.

Un bloc 72 de diagnostic de vieillissement fournit un signal de vieillissement en fonction des entrées représentant $R_0$, I et l'état de conduite.

Ces signaux fournis par les blocs 64, 66, 68, 70 et 72 sont appliqués sur des entrées respectives d'un bloc 74 de gestion des alarmes ou alertes. Par exemple, en cas de surcharge, on force la puissance disponible en charge à zéro et, en cas de décharge profonde, on force la puissance de décharge à zéro.

**Revendications**

1. Procédé pour la détermination d'au moins un paramètre de fonctionnement de la batterie (12) de puissance d'un véhicule comportant un moteur de traction électrique, **caractérisé en ce que** :

   - le paramètre de la batterie est constitué par au moins un des paramètres suivants : la puissance de charge, la puissance de décharge, l'état de surcharge et l'état de décharge profonde, et
   - on détermine la résistance interne de la batterie de puissance et l'intensité du courant fourni ou reçu pour estimer le ou les paramètres.

2. Procédé selon la revendication 1 **caractérisé en ce que** le paramètre étant l'état de puissance de charge et/ou de décharge de la batterie, l'estimation de la puissance de charge et/ou décharge fait appel à l'équation suivante :

$$P = U\frac{E \pm U}{R} \qquad (1),$$

   formule dans laquelle U est la tension aux bornes de la batterie de puissance, E est la force électromotrice ou contre-électromotrice et R sa résistance interne, le signe + correspondant à la charge de la batterie et le signe - à la décharge de la batterie.

3. Procédé selon la revendication 1 ou 2 **caractérisé en ce que** le paramètre étant l'état de surcharge, on détermine le seuil $U_{max}$ de tension aux bornes de la batterie à partir de la formule suivante :

$$U_{max} = E_{N\%} + R_{N\%} \, I,$$

   formule dans laquelle $E_{N\%}$ est la force contre-électromotrice de la batterie pour un état de charge déterminé supérieur à un état de charge nominal, $R_{N\%}$ est la résistance interne de la batterie pour ce même état de charge, et I est l'intensité du courant absorbé par la batterie.

4. Procédé selon l'une quelconque des revendications précédentes **caractérisé en ce que** le paramètre étant l'état de décharge profonde, on détermine le seuil $U_{min}$ de tension aux bornes de la batterie en dessous duquel il est estimé que la batterie est en décharge profonde à l'aide de la formule suivante :

$$U_{min} = E_{n\%} - R_{n\%} \, I,$$

   formule dans laquelle $E_{n\%}$ est la force électromotrice pour un état de charge inférieur à une valeur nominale, $R_{n\%}$ est la valeur de la résistance interne de la batterie pour le même état de charge inférieur à la valeur nominale, et I est l'intensité du courant fourni par la batterie.

5. Procédé selon l'une quelconque des revendications 2 à 4 **caractérisé en ce que** la force électromotrice ou contre-électromotrice de la batterie est prédéterminée en fonction de l'état de charge (SOC).

6. Procédé selon la revendication 5 **caractérisé en ce que** la force électromotrice ou contre-électromotrice est également prédéterminée en fonction de la température de la batterie.

7. Procédé selon l'une quelconque des revendications précédentes **caractérisé en ce qu'**on affecte à chaque valeur mesurée de résistance interne de la batterie un terme correctif qui dépend de l'état de polarisation de la batterie.

8. Procédé selon la revendication 7 **caractérisé en ce qu'**on fait dépendre le terme correctif de la température.

9. Procédé selon la revendication 7 ou 8 **caractérisé en ce qu'**on fait dépendre le terme correctif du paramètre à estimer.

10. Procédé selon la revendication 9, **caractérisé en ce qu'**on fait dépendre le terme correctif du temps au bout duquel le paramètre doit être estimé.

11. Procédé selon l'une quelconque des revendications précédentes **caractérisé en ce qu'**on détermine en outre la résistance interne en vue de détecter l'état de vieillissement de la batterie.

12. Procédé selon l'une quelconque des revendications précédentes **caractérisé en ce que** la résistance interne de la batterie est déterminée à l'aide d'une batterie auxiliaire (18) basse tension reliée à la batterie de puissance par l'intermédiaire d'un convertisseur continu-continu (20) de type réversible.

13. Procédé selon la revendication 12 **caractérisé en ce que** l'estimation de la résistance interne est effectuée lorsque la batterie est hors contact.

14. Procédé selon la revendication 13 **caractérisé en ce que** l'estimation de la résistance interne est effectuée de façon périodique de façon automatique, par exemple simultanément à des périodes d'estimation d'autodécharge de la batterie de puissance.

15. Procédé selon l'une des revendications précédentes, **caractérisé en ce que** la détermination d'au moins un paramètre de fonctionnement de la batterie de puissance du véhicule comportant la détermination de la résistance interne de la batterie de puissance et de l'intensité du courant fourni ou reçu pour estimer le ou les paramètre(s), est déclenchée à l'aide d'un signal externe au véhicule et **en ce que** le résultat de l'estimation est recueilli à l'extérieur du véhicule.

16. Application du procédé selon l'une quelconque des revendications précédentes à l'estimation de paramètres d'une batterie de puissance d'un véhicule de type hybride comprenant, outre le moteur de traction électrique, un moteur de traction de type thermique qui est également utilisé pour charger la batterie par l'intermédiaire d'un alternateur.

## FIG_1

## FIG_2

## FIG_3

FIG_4a

FIG_4b

FIG_4c

**Office européen des brevets**

## RAPPORT DE RECHERCHE EUROPEENNE

Numéro de la demande

EP 02 29 1831

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 1 081 499 A (TOYOTA MOTOR CO LTD) 7 mars 2001 (2001-03-07) * le document en entier * | 1-6, 8-11,14 | G01R31/36 |
| X | US 5 936 383 A (NG PATRICK KWOK-YEUNG ET AL) 10 août 1999 (1999-08-10) * revendication 1 * | 1,11 | |
| X | US 4 968 942 A (PALANISAMY THIRUMALAI G) 6 novembre 1990 (1990-11-06) * revendication 1 * | 1,7 | |
| X | US 5 428 560 A (LEON SERGE ET AL) 27 juin 1995 (1995-06-27) * revendications 1,2 * | 1 | |

DOMAINES TECHNIQUES RECHERCHES (Int.Cl.7)

G01R

Le présent rapport a été établi pour toutes les revendications

| Lieu de la recherche | Date d'achèvement de la recherche | Examinateur |
|---|---|---|
| LA HAYE | 18 septembre 2002 | Six, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

**ANNEXE AU RAPPORT DE RECHERCHE EUROPEENNE
RELATIF A LA DEMANDE DE BREVET EUROPEEN NO.**   EP 02 29 1831

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-09-2002

| Document brevet cité au rapport de recherche | | Date de publication | Membre(s) de la famille de brevet(s) | | Date de publication |
|---|---|---|---|---|---|
| EP 1081499 | A | 07-03-2001 | EP | 1081499 A1 | 07-03-2001 |
| | | | US | 6285163 B1 | 04-09-2001 |
| | | | CN | 1311860 T | 05-09-2001 |
| | | | WO | 9961929 A1 | 02-12-1999 |
| US 5936383 | A | 10-08-1999 | AUCUN | | |
| US 4968942 | A | 06-11-1990 | US | 4937528 A | 26-06-1990 |
| | | | EP | 0460117 A1 | 11-12-1991 |
| | | | JP | 4505053 T | 03-09-1992 |
| | | | JP | 3213740 B2 | 02-10-2001 |
| | | | WO | 9010242 A2 | 07-09-1990 |
| | | | DE | 68924169 D1 | 12-10-1995 |
| | | | DE | 68924169 T2 | 21-03-1996 |
| | | | EP | 0438477 A1 | 31-07-1991 |
| | | | JP | 2966870 B2 | 25-10-1999 |
| | | | JP | 4502963 T | 28-05-1992 |
| | | | WO | 9004188 A1 | 19-04-1990 |
| | | | US | 5281919 A | 25-01-1994 |
| US 5428560 | A | 27-06-1995 | FR | 2689986 A1 | 15-10-1993 |
| | | | DE | 69323108 D1 | 04-03-1999 |
| | | | DE | 69323108 T2 | 17-06-1999 |
| | | | EP | 0565405 A1 | 13-10-1993 |
| | | | ES | 2129504 T3 | 16-06-1999 |

EPO FORM P0460

Pour tout renseignement concernant cette annexe : voir Journal Officiel de l'Office européen des brevets, No. 12/82